# EUROPEAN PATENT APPLICATION

(11) **EP 4 027 519 A1**
(43) Date of publication of application: **13.07.2022**
(21) Application number: 20860269.8
(22) Date of filing: 24.04.2020
(51) Int. Cl.: H03H 9/17, H03H 9/02, H03H 3/02

(54) **BULK ACOUSTIC WAVE RESONATOR AND MANUFACTURING METHOD THEREFOR, FILTER AND ELECTRONIC DEVICE**

(30) Priority: 03.09.2019 CN 201910825808
(71) Applicant: Tianjin University, Tianjin 300072 (CN); Rofs Microsystem (Tianjin) Co., Ltd, Tianjin 300462 (CN)
(72) Inventor: YANG, Qingrui, Tianjin 300072 (CN); PANG, Wei, Tianjin 300072 (CN); ZHANG, Menglun, Tianjin 300072 (CN)
(74) Representative: Meyer-Dulheuer MD Legal Patentanwälte PartG mbB
(86) International application number: PCT/CN2020/086561
(87) International publication number: WO 2021/042740

(57) **Abstract**

A bulk acoustic wave resonator includes: a substrate; an acoustic mirror (10); a bottom electrode (11); a top electrode (13); and a piezoelectric layer (12), wherein: an area where the acoustic mirror (10), the bottom electrode (11), the piezoelectric layer (12), and the top electrode (13) overlap in the thickness direction of the substrate is an effective area of the resonator; the resonator further includes an etching stop layer for the bottom electrode (11), the etching stop layer being arranged on the top surface of the bottom electrode (11); the inner end of the etching stop layer is located within the effective area in a cross-sectional view of the resonator and overlaps with the top electrode (13), and an end portion of the top electrode (13) forms a step structure on the basis of the overlap. The present application further relates to a filter and an electronic device, as well as a manufacturing method for the bulk acoustic wave resonator.

## Description

### TECHNICAL FIELD

Embodiments of the present disclosure relate to the field of semiconductors, and in particular, to a bulk acoustic wave resonator, a filter, an electronic device having one of the bulk acoustic wave resonator and the filter, and a method for manufacturing the bulk acoustic wave resonator.

### BACKGROUND

With the rapid popularization of wireless communication devices, the demand for high-frequency filters with small size and excellent performance is increasing, and a film bulk acoustic resonator formed on a silicon wafer has been widely accepted by the market. The film bulk acoustic resonator (FBAR, also known as bulk acoustic wave resonator (BAW)) is very important as a MEMS chip in the field of communication. FBAR filters are gradually replacing conventional surface acoustic wave (SAW) filters and ceramic filters due to their small size (µm level), high resonant frequency (GHz), high quality factor (1000), large power capacity, good roll-off effect, and other excellent characteristics.

A resonant frequency of the bulk acoustic wave resonator is determined by a thickness of each layer and an acoustic velocity of longitudinal acoustic waves in each layer in a propagation path. The resonance frequency is mainly affected by thicknesses of a piezoelectric layer and two electrodes and the acoustic velocity thereof. An acoustic reflection mirror formed by a cavity has a negligible effect on the resonant frequency because the acoustic reflection mirror can reflect nearly all acoustic energy back to the piezoelectric layer. If the acoustic reflection mirror is formed by alternatively arranging high and low acoustic impedance layers, a top layer of the acoustic reflection mirror contains a small fraction of the acoustic energy, so that the acoustic reflection mirror may affect the resonant frequency. For the film bulk acoustic resonator, the relationship between the resonant frequency f, the acoustic velocity v of the acoustic wave and the thickness D of each layer is f=v/2D. Since the acoustic wave has a constant propagation velocity, the higher a frequency of the resonator, the thinner a thickness of each film is. Therefore, for a film bulk acoustic resonator with a high-frequency greater than 3 GHz, top and bottom electrodes both have thinner thickness, resulting in increased resistance and poorer electrical parameters such as filter insertion loss.

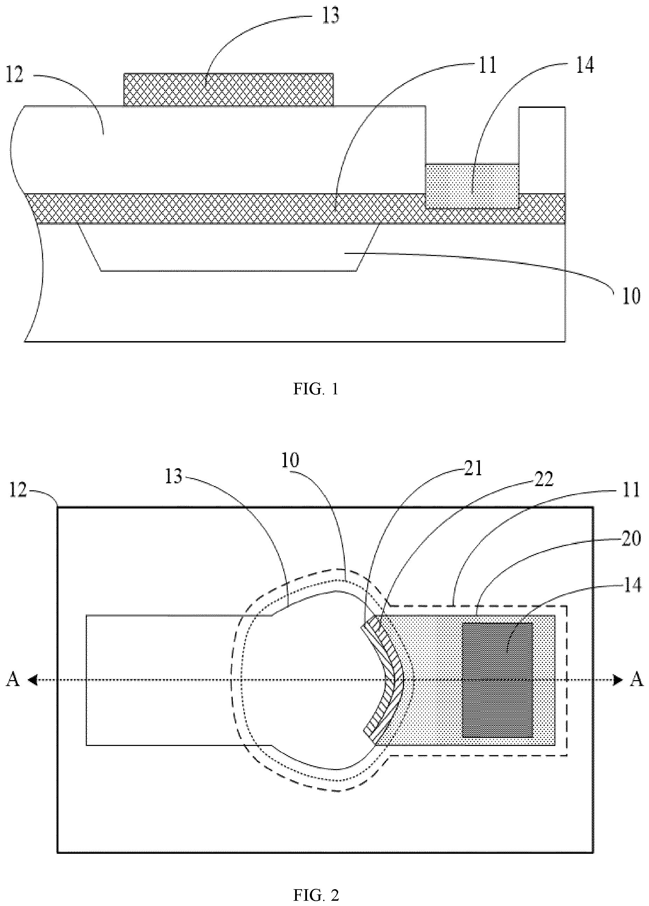

FIG. 1 is a schematic structural view of a conventional film bulk acoustic resonator. As shown in FIG. 1, a reference sign 10 indicates a cavity structure of the resonator, a reference sign 11 indicates a bottom electrode, a reference sign 12 indicates a piezoelectric layer, a reference sign 13 indicates a top electrode, and a reference sign 14 indicates a metal connection layer arranged on the bottom electrode. As for the conventional high-frequency resonator, the electrode has a thinner thickness and thus a series resistance Rₛ becomes larger, which increases the electrical energy loss in the electrodes. Accordingly, a Q value of the resonator is reduced. Meanwhile, since the bottom electrode 11 has a thinner thickness, the bottom electrode may be over-etched and damaged in a process during which the piezoelectric layer 12 above the bottom electrode 11 is etched to form the metal connection layer 14 on the bottom electrode. This results in worse electrical connection of the resonator and reduces reliability of the resonator. In addition, a discontinuity in acoustic impedance at an interface between the electrodes and the piezoelectric layer of the resonator, and thus acoustic waves in other modes are excited. The acoustic waves in these modes cannot be confined inside the resonator, and some of the acoustic wave energy is transferred outside of the resonator and lost, which reduces a quality factor of the resonator.

### SUMMARY

The present disclosure is made in order to solve at least one aspect of the technical problems in the related art.

In the present disclosure, an etching barrier layer for the bottom electrode is provided in a resonator such that it is possible to prevent a bottom electrode from being etched during forming of a metal connection layer on the bottom electrode, while a series resistance Rₛ and an electrical loss in the bottom electrode can be reduced and a Q value of the resonator can be improved. In addition, an inner end of the etching barrier layer is etched to form a stepped portion at an end portion of a top electrode, such that a transverse acoustic wave mode at an edge of the resonator can be reflected back into an effective region and is partially converted into acoustic waves in a longitudinal mode perpendicular to a surface of a piezoelectric layer, thereby further improving the Q value of the resonator. With the etching barrier layer of the single structure, reliability of the resonator and the Q value thereof both can be improved in term of the reduction of the electrical losses and the reflection of the acoustic waves.

According to an aspect of embodiments of the present disclosure, there is provided a bulk acoustic wave resonator. The bulk acoustic wave resonator includes a substrate, an acoustic mirror, a bottom electrode, a top electrode, and a piezoelectric layer. The acoustic mirror, the bottom electrode, the piezoelectric layer and the top electrode overlap with each other in a thickness direction of the resonator to form an overlapping region, which is an effective region of the resonator. The resonator further includes an etching barrier layer for the bottom electrode. The etching barrier layer is arranged on an upper surface of the bottom electrode. The etching barrier layer has an inner end that is located within the effective region and overlaps with the top electrode in a top view of the resonator, and the tope electrode has an end portion formed into a stepped structure through the overlapping.

Alternatively, the etching barrier layer includes a first metallic layer and a second metallic layer. The first metallic layer and the second metallic layer are arranged on the bottom electrode in such a manner that the second metallic layer is stacked on the first metallic layer, and the first metallic layer has an inner end located closer to a center of the effective region than an inner end of the second metallic layer in a radial direction. The resonator further includes a bottom electrode electrical connection layer directly electrically connected to the second metallic layer outside the effective region.

Alternatively, the inner end of the first metallic layer and the inner end of the second metallic layer both overlap with the end portion of the top electrode in the top view of the resonator. The stepped structure is a double-stepped structure. Further, the resonator further includes a metallic extending portion extending from the first metallic layer and/or the second metallic layer on a same layer along at least part of the effective region. A portion of the top electrode overlapping with the metallic extending portion in the top view of the resonator is formed with a stepped extension structure.

Alternatively, the inner end of the first metallic layer overlaps with the end portion of the top electrode in the top view of the resonator, and the inner end of the second metallic layer is located outside the effective region. The end portion of the top electrode is formed into a single-step structure. Further, alternatively, the resonator further includes a metallic extending portion extending from a portion of the first metallic layer within the effective region and/or portions of the first metallic layer and the second metallic layer within the effective region on a same layer along at least part of the effective region. A portion of the top electrode overlapping with the metallic extending portion in the top view of the resonator is formed with a stepped extension structure.

Alternatively, the first metallic layer has a thickness in a range of 10 Å to 5000 Å, and/or the second metallic layer has a thickness in a range of 10 Å to 10000 Å.

Alternatively, the first metallic layer is made of a material with high acoustic impedance, and the second metallic layer is made of a material with low electrical loss.

Alternatively, the etching barrier layer includes a non-metallic layer provided on the upper surface of the bottom electrode. The non-metallic layer has an inner end located within the effective region and overlaps with the top electrode. The end portion of the top electrode is formed into a stepped structure through the overlapping, and the resonator further includes a bottom electrode electrical connection layer abutting against the non-metallic layer in a radial direction. Further, the bottom electrode electrical connection layer of the resonator is directly electrically connected to the bottom electrode.

Alternatively, the etching barrier layer further includes a third metallic layer provided between the bottom electrode and the non-metallic layer. The third metallic layer is electrically connected to the bottom electrode, and the bottom electrode electrical connection layer is directly electrically connected to the third metallic layer outside the effective region.

Alternatively, the third metallic layer has an inner end located within the effective region, the inner end of the third metallic layer is located farther from a center of the effective region than the inner end of the non-metallic layer in the radial direction in the top view of the resonator, and the end portion of the top electrode is formed into a double-step structure through the inner end of the third metallic layer and the inner end of the non-metallic layer staggered from each other in the radial direction.

Alternatively, the third metallic layer has an inner end located within the effective region, the inner end of the third metallic layer is located closer to a center of the effective region than the inner end of the non-metallic layer in the radial direction in the top view of the resonator, and the end portion of the top electrode is formed into a double-step structure through the inner end of the third metallic layer and the inner end of the non-metallic layer staggered from each other in the radial direction.

Alternatively, the etching barrier layer further includes a fourth metallic layer provided between the substrate and the bottom electrode, and the fourth metallic layer extending through the bottom electrode electrical connection layer in the radial direction in the top view of the resonator.

Alternatively, the resonator further includes a non-metallic extending portion from a portion of the non-metallic layer in contact with the bottom electrode within the effective region on a same layer along at least part of the effective region. A portion of the top electrode overlapping with the non-metallic extending portion in the top view of the resonator is formed with a stepped extension structure.

According to another aspect of the present disclosure, there is provided a filter including the bulk acoustic wave resonator as described above.

According to a further another aspect of the present disclosure, there is provided an electronic device including the bulk acoustic wave resonator as described above or the filter as described above.

According to a yet another aspect of the present disclosure, there is provided a method for manufacturing a bulk acoustic wave resonator. The bulk acoustic wave resonator includes a substrate, an acoustic mirror, a bottom electrode, a top electrode and a piezoelectric layer. The acoustic mirror, the bottom electrode, the piezoelectric layer and the top electrode overlap with each other in a thickness direction of the substrate to form an overlapping region, which is an effective region of the resonator. The method includes: providing an etching barrier layer for the bottom electrode on an upper surface of the bottom electrode, the etching barrier layer having an inner end located within the effective region; forming a piezoelectric layer stepped portion on the piezoelectric layer covering the etching barrier layer through the inner end of the etching barrier layer; and providing the top electrode on the piezoelectric layer, an end portion of the top electrode being formed into a stepped structure through the piezoelectric layer stepped portion.

Alternatively, the etching barrier layer includes a non-metallic layer, and the method includes: providing the non-metallic layer, the non-metallic layer covering a predetermined portion of the upper surface of the bottom electrode and extending radially outward from an inner side of an edge of the effective region; providing the piezoelectric layer, the piezoelectric layer covering the bottom electrode and the non-metallic layer, and the piezoelectric layer being formed with a piezoelectric layer stepped portion through an inner end of the non-metallic layer in the effective region; etching the piezoelectric layer and the non-metallic layer at a predetermined position to form a through hole; and depositing a bottom electrode electrical connection layer within the through hole, the bottom electrode electrical connection layer being electrically connected to the bottom electrode.

Alternatively, the etching barrier layer includes a non-metallic layer and a metallic layer, and the method includes: providing the metallic layer at a predetermined position of the bottom electrode, the metallic layer being electrically connected to the bottom electrode; providing the non-metallic layer on the metallic layer, the non-metallic layer extending radially outward from an inner side of an edge of the effective region and having an inner end, and the inner end of the non-metallic layer being located closer to or farther from a center of the effective region than an inner end of the metallic layer in the radial direction; providing the piezoelectric layer, the piezoelectric layer covering the bottom electrode and the non-metallic layer or the metallic layer, and the piezoelectric layer being formed with a piezoelectric layer stepped portion through the inner end of the non-metallic layer within the effective region or through inner ends of the metallic layer and non-metallic layer staggered from each other in the radial direction; etching the piezoelectric layer and the non-metallic layer at a predetermined position to form a through hole; and depositing a bottom electrode electrical connection layer within the through hole, the bottom electrode electrical connection layer being electrically connected to the metallic layer.

Alternatively, the etching barrier layer includes a first metallic layer and a second metallic layer, and the method includes: providing the first metallic layer and the second metallic layer stacked on each other at predetermined positions of the upper surface of the bottom electrode, the first metallic layer being electrically connected to the bottom electrode and the second metallic layer, and the first metallic layer having an inner end located closer to a center of the effective region than an inner end of the second metallic layer in a radial direction; providing the piezoelectric layer, the piezoelectric layer covering the bottom electrode and a portion of the first metallic layer and the second metallic layer, and the piezoelectric layer being formed with a piezoelectric layer stepped portion through the inner end of the first metallic layer or the inner ends of the first metallic layer and second metallic layer staggered from each other in the radial direction; etching the piezoelectric layer at a predetermined position to form a through hole; and depositing a bottom electrode electrical connection layer within the through hole, the bottom electrode electrical connection layer being electrically connected to the second metallic layer.

### BRIEF DESCRIPTION OF DRAWINGS

The following description and drawings can facilitate to understand these and other features and advantages in various embodiments disclosed in the present disclosure. The same reference signs in the drawings always indicate the same components, wherein:
FIG. 1 is a schematic sectional view of a bulk acoustic wave resonator in the related art;
FIG. 2 is a schematic top view of a bulk acoustic wave resonator according to an exemplary embodiment of the present disclosure;
FIG. 3 is a schematic partial sectional view of the bulk acoustic wave resonator along line A-A in FIG. 2 according to an exemplary embodiment of the present disclosure;
FIG. 4 is a schematic top view of a bulk acoustic wave resonator according to another exemplary embodiment of the present disclosure;
FIG. 5 is a schematic partial sectional view of the bulk acoustic wave resonator along line A-A in FIG. 4 according to an exemplary embodiment of the present disclosure;
FIG. 6 is a schematic top view of a bulk acoustic wave resonator according to a further another exemplary embodiment of the present disclosure;
FIG. 7 is a schematic sectional view of the bulk acoustic wave resonator along line B-B in FIG. 6 according to an exemplary embodiment of the present disclosure;
FIG. 8 is a schematic partial sectional view of a bulk acoustic wave resonator according to an exemplary embodiment of the present disclosure;
FIG. 9 is a schematic partial sectional view of a bulk acoustic wave resonator according to an exemplary embodiment of the present disclosure;
FIG. 10 is a schematic partial sectional view of a bulk acoustic wave resonator according to an exemplary embodiment of the present disclosure;
FIG. 11 is a schematic partial sectional view of a bulk acoustic wave resonator according to an exemplary embodiment of the present disclosure; and
FIG. 12 is a schematic partial sectional view of a bulk acoustic wave resonator according to an exemplary embodiment of the present disclosure.

### DESCRIPTION OF EMBODIMENTS

The technical solutions of the present disclosure will be further described below in detail through embodiments and in conjunction with the drawings. The same or similar reference signs indicate the same or similar components throughout the description. The following description of embodiments of the present disclosure with reference to the drawings is intended to explain the general concept of the present disclosure, and should not be construed as a limitation to the present disclosure.

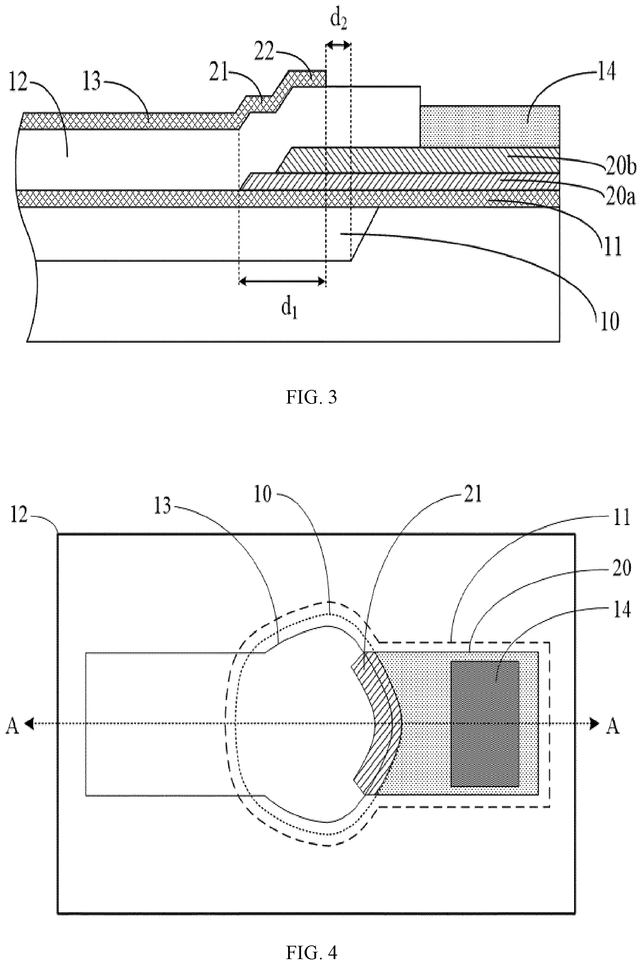

FIG. 2 is a schematic top view of a bulk acoustic wave resonator according to an exemplary embodiment of the present disclosure, and FIG. 3 is a schematic partial sectional view of the bulk acoustic wave resonator along line A-A in FIG. 2 according to an exemplary embodiment of the present disclosure.

FIG. 2 illustrates a top view of a film bulk acoustic wave resonator. As shown in FIG. 2, a reference sign 10 indicates an acoustic mirror arranged at a bottom of the resonator, a reference sign 11 indicates a bottom electrode of the resonator, a reference sign 12 indicates a piezoelectric layer of the resonator, a reference sign 13 indicates a top electrode of the resonator, a reference sign 14 indicates a bottom electrode metal connection layer arranged above the bottom electrode of the resonator, a reference sign 20 indicates a metallic layer, a reference sign 21 indicates a first protrusion structure, and a reference sign 22 indicates a second protrusion structure. In this embodiment, the metallic layer includes a first metallic layer located below the bottom electrode and a second metallic layer arranged above the piezoelectric layer, and the first metallic layer and the second metallic layer overlap with the top electrode in a vertical direction to form an overlapping portion, in which the two metallic layers do not overlap with each other.

As shown in FIG. 3, the bulk acoustic wave resonator includes the acoustic mirror 10, the bottom electrode 11, the first metallic layer 20a and the second metallic layer 20b located above the bottom electrode, the piezoelectric layer 12, the top electrode 13, the first protrusion structure 21, the second protrusion structure 22, and the bottom electrode metal connection layer 14 arranged sequentially in the vertical direction. The acoustic mirror 10 may be a cavity structure etched in the substrate or a cavity structure protruding upwardly from the substrate, or an acoustic wave reflection structure such as a Bragg reflection structure. In the embodiment as shown in FIG. 3, the acoustic mirror is the cavity structure etched in the substrate.

The bottom electrode, the piezoelectric layer, the top electrode and the cavity structure overlap with each other in the vertical direction to form an overlapping region, which is an effective region of the resonator.

The top electrode is located within the cavity structure, and a distance between the top electrode and an edge of the cavity structure is d₂ in a range of 0 to 10 µm. Further, the first metallic layer and the second metallic layer partially overlap with the top electrode 13 in the vertical direction in an overlapping region, and the overlapping region has a width d₁. Furthermore, the first metallic layer and the second metallic layer are staggered in the overlapping region to form the first protrusion structure and the second protrusion structure on the top electrode. The first metallic layer has a thickness in a range of generally 10 Å to 5000 Å, and the second metallic layer has a thickness greater than that of the first metallic layer in a range of generally 10 Å to 10000 Å.

It should be specially noted that, in the present disclosure, for the numerical range, the numerical value may not only be end values of the numerical range, but also be mean values or midpoint values within the numerical range.

In this embodiment, since the first metallic layer and the second metallic layer are arranged on the bottom electrode, the bottom electrode will not be damaged during the etching of the piezoelectric layer on the bottom electrode. Further, since the metallic layers of the bottom electrode has an increased total thickness, a series resistance Rₛ of the bottom electrode can be effectively reduced, so that the electrical energy loss of the bottom electrode is reduced, thereby improving a Q value of the resonator. Meanwhile, the first protrusion structure and the second protrusion structure are formed on an upper surface of the top electrode due to the first metallic layer and the second metallic layer, and thus an impedance mismatching characteristic between the first protrusion structure and the second protrusion structure reflects a transverse acoustic wave mode at an edge of the resonator back into the effective region and partially convert the transverse acoustic wave mode into a longitudinal acoustic wave mode perpendicular to a surface of the piezoelectric layer, thereby further improving the Q value of the resonator. In general, a thickness of the protrusion structure is correlated with the performance of the resonator, and the resonator has an optimized performance in an optimal thickness range. Moreover, since the first protrusion structure is located closer to a center of the resonator, an optimal thickness of the first protrusion structure is limited by a stacking thickness of the resonator. The second protrusion structure is located farther from the center of the resonator than the first protrusion structure, and thus has a thickness in a wider range. Therefore, a thicker etching barrier layer is formed in a non-effective region. Furthermore, when the first metallic layer 20a is made of a metal material with a high acoustic impedance such as molybdenum, ruthenium, tungsten, platinum, osmium, iridium, rhenium and other similar material, the acoustic impedance mismatch of adjacent regions is improved, thereby enhancing the acoustic reflection and improving the Q value of the resonator. In addition, when the second metallic layer is made of a metal material with low electrical loss such as aluminum, gold, aluminum alloy and other similar materials, the electrical loss of the resonator is greatly reduced.

In the present disclosure, the metal material with a high acoustic impedance means that the metal material has an acoustic impedance greater than 30 MegaRayls, preferably more than 50 MegaRayls. The metal material with low electrical loss means that the metal material has a resistivity lower than 3.5×10⁻⁸ Ohm·m.

In the embodiment as shown in FIGS. 2 and 3, the etching barrier layer includes the first metallic layer and the second metallic layer. The first metallic layer and the second metallic layer are arranged on the bottom electrode in such a manner that the second metallic layer is stacked on the first metallic layer. Further, the first metallic layer has an inner end closer to a center of the effective region than an inner end of the second metallic layer in a radial direction. The bottom electrode electrical connection layer of the resonator is directly electrically connected to the second metallic layer outside the effective region.

As shown in FIG. 3, the inner end of the first metallic layer and the inner end of the second metallic layer both overlap with an end portion of the top electrode in a top view of the resonator, and the end portion of the top electrode is formed into a stepped structure that is a double-stepped structure.

In the present disclosure, the inner end refers to an end closer to the center of the effective region in the radial or lateral direction, and an outer end refers to an end farther from the center of the effective region in the radial or lateral direction.

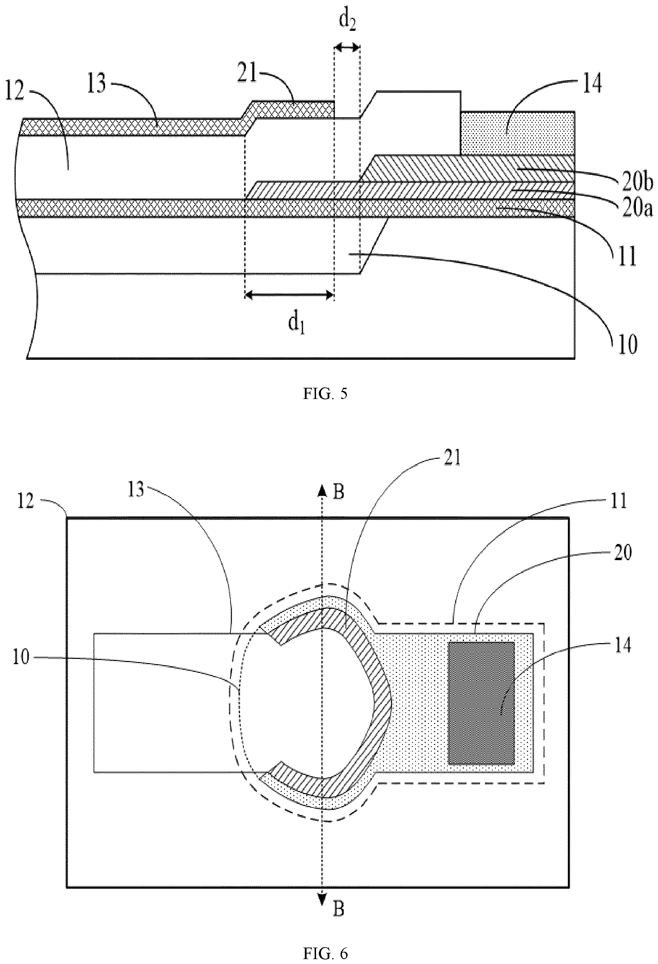

In the embodiment as shown in FIG. 2 and 3, the inner ends of the first metallic layer and second metallic layer are both arranged within the effective region. However, the inner end of the first metallic layer may be only arranged within the effective region, which also falls within the scope of the present disclosure. FIGS. 4 and 5 illustrate such an embodiment. FIG. 4 is a schematic top view of a bulk acoustic wave resonator according to another exemplary embodiment of the present disclosure, and FIG. 5 is a schematic partial sectional view of the bulk acoustic wave resonator along line AA in FIG. 4 according to an exemplary embodiment of the present disclosure.

The structure shown in FIG. 4 is similar to that shown in FIG. 2, except that only one protrusion structure is provided, and only one of the metallic layers is located within the overlapping region where the metallic layers overlap with the top electrode and the other metallic layer is located outside the overlapping region, in the embodiment shown in FIG. 4.

The structure shown in FIG. 5 is similar to that shown in FIG. 3 except that the second metallic layer 20b is located outside the effective region of the resonator in the embodiment shown in FIG. 5. In this case, the second metallic layer 20b has a thicker thickness in a range of 10 Å to 10000 Å. In addition, only one protrusion structure is formed at the overlapping region where the first metallic layer 20a overlaps with the top electrode 13 in the vertical direction, and has an increased width. Therefore, the Rₚ value of the resonator can be effectively improved by increasing the width of the protrusion structure.

As shown in FIG. 5, the inner end of the first metallic layer overlaps with the end portion of the top electrode in the top view of the resonator, and the inner end of the second metallic layer is located outside the effective region. Further, the end portion of the top electrode is formed into a single-stepped structure.

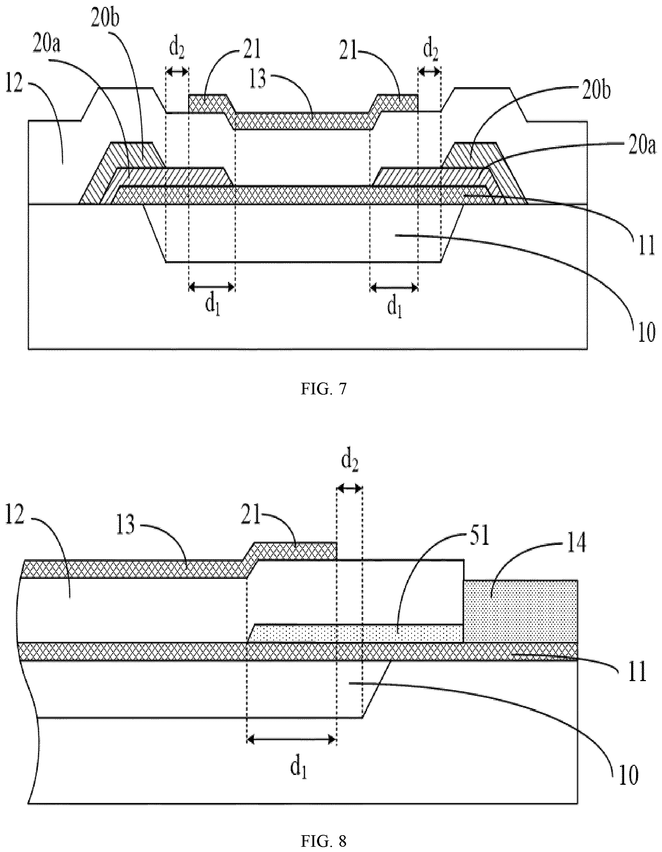

In the embodiments as shown in FIGS. 2 to 5, the etching barrier layer is a metallic layer. However, the present disclosure is not limited thereto. The etching barrier layer may be a non-metallic layer. FIG. 8 shows an exemplary embodiment of a non-metallic layer.

FIG. 8 is a schematic partial sectional view of a bulk acoustic wave resonator according to an exemplary embodiment of the present disclosure. As shown in FIG. 8, the resonator incudes an acoustic mirror structure 10, a bottom electrode 11, a non-metallic layer 51 arranged on the bottom electrode, a piezoelectric layer 12, a top electrode 13, a protrusion structure 21, and a bottom electrode metal connection layer 14 sequentially arranged in a vertical direction of the resonator. The acoustic mirror structure 10 may be a cavity structure etched in the substrate or a cavity structure protruding upwardly from the substrate, or an acoustic wave reflection structure such as a Bragg reflection structure. In the embodiment as shown in FIG. 8, the acoustic mirror structure is the cavity structure etched in the substrate. In this embodiment, the non-metallic layer is used as an etching barrier layer, which prevents the bottom electrode and the metallic layer from being etched by an etchant when the piezoelectric layer on the bottom electrode is etched. Meanwhile, when the non-metallic layer is made of a temperature-compensating material such as polysilicon, borophosphate glass (BSG), silicon dioxide (SiO₂), chromium (Cr), or tellurium oxide (TeO(x)), the non-metallic layer compensates for a temperature of the resonator. Accordingly, the resonator can adapt to changes in the environment temperature and thus is applicable in various environments. Moreover, the non-metallic layer 51 can electrically isolate the bottom electrode from the piezoelectric layer in a region d₁ so that deterioration of a Kt value of the resonator and generation of a sub-resonance is effectively avoided in the region d₁. In particular, when the non-metallic layer is made of a material same as that of a sacrificial layer, such as silicon dioxide (SiO₂) and phosphosilicate glass (PSG), a hydrofluoric acid passes through the piezoelectric layer of aluminum nitride to etch away the non-metallic layer so as to form an air gap as a bridge structure during the release of the sacrificial layer through the hydrofluoric acid. The bridge structure reflects acoustic waves in a transverse mode in the resonator back into the effective region of the resonator, thereby further improving the Q value of the resonator.

Accordingly, the etching barrier layer includes the non-metallic layer arranged on an upper surface of the bottom electrode, and the non-metallic layer has an inner end located in the effective region and overlapping with the top electrode. An end portion of the top electrode is formed into a stepped structure due to the overlapping, and the bottom electrode electrical connection layer of the resonator abuts against the non-metallic layer in a radial direction. As shown in FIG. 8, the bottom electrode electrical connection layer of the resonator is directly electrically connected to the bottom electrode.

As shown in FIG. 8, the end portion of the top electrode 13 is formed into a single-stepped structure 21 as the inner end of the non-metallic layer 51.

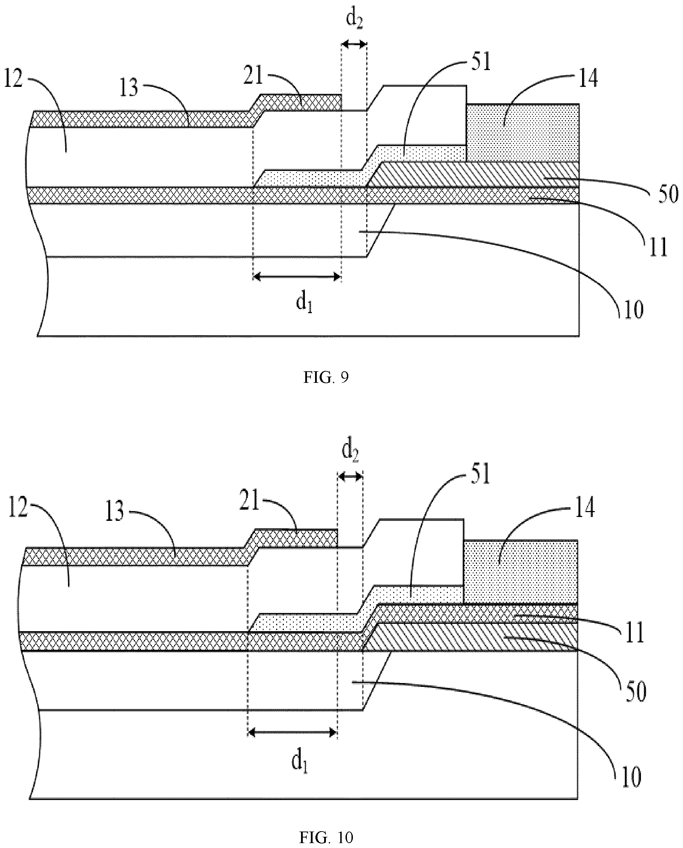

The etching barrier layer may include a non-metallic layer and a metallic layer, and FIG. 9 shows an exemplary embodiment of such an etching barrier layer.

FIG. 9 is a schematic partial sectional view of a bulk acoustic wave resonator according to an exemplary embodiment of the present disclosure. The structure shown in FIG. 9 is similar to that shown in FIG. 8 except that a metallic layer 50 is located on the bottom electrode in the embodiment shown in FIG. 9. The metallic layer 50 can reduce the electrical energy loss of the bottom electrode, i.e., reduce the series resistance Rₛ of the bottom electrode of the resonator.

Accordingly, in the embodiment shown in FIG. 9, the etching barrier layer includes a non-metallic layer 51 and a third metallic layer (i.e., the metallic layer 50) provided between the bottom electrode and the non-metallic layer. The third metallic layer is electrically connected to the bottom electrode. The bottom electrode electrical connection layer is directly electrically connected to the third metallic layer outside the effective region and abuts against the non-metallic layer in the radial direction.

As shown in FIG. 9, the end portion of the top electrode 13 is formed into a single-stepped structure 21 as the inner end of the non-metallic layer 51.

FIG. 10 is a schematic partial sectional view of a bulk acoustic wave resonator according to an exemplary embodiment of the present disclosure. The structure shown in FIG. 10 is similar to that shown in FIG. 9 except that the metallic layer 50 is located below the bottom electrode 11 in FIG. 10. As shown in FIG. 10, the end portion of the top electrode 13 is formed into a single-stepped structure 21 as the inner end of the non-metallic layer 51. Therefore, in the embodiment shown in FIG. 10, the etching barrier layer further includes a fourth metallic layer (indicated by a reference sign 50 in FIG. 10) arranged between the substrate and the bottom electrode. The fourth metallic layer extends beyond the bottom electrode electrical connection layer in the radial direction in the top view of the resonator. The fourth metallic layer 50 can reduce the electrical energy loss of the bottom electrode, i.e., reduce the series resistance Rₛ of the bottom electrode of the resonator.

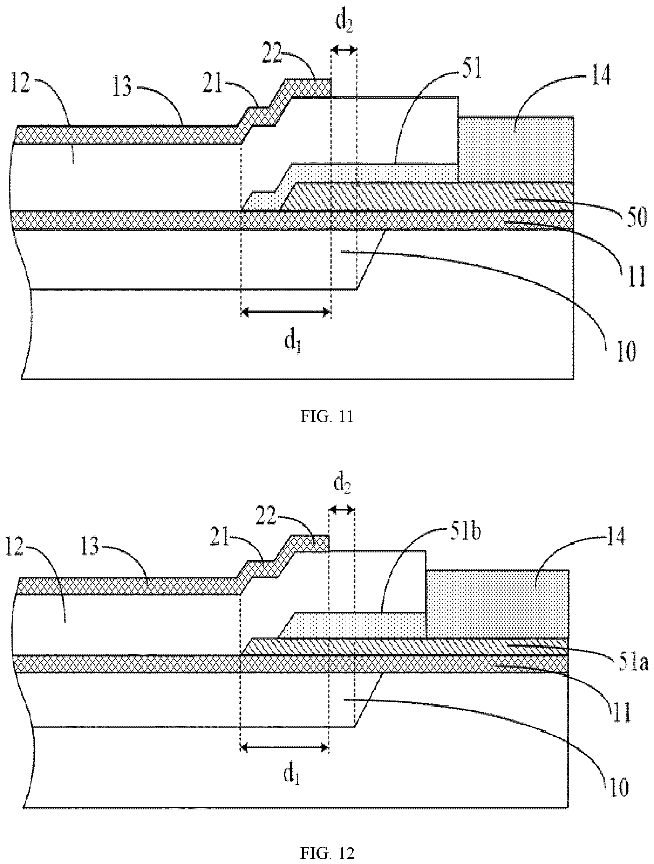

FIG. 11 is a schematic partial sectional view of a bulk acoustic wave resonator according to an exemplary embodiment of the present disclosure. The structure shown in FIG. 11 is similar to that shown in FIG. 9 except that the metallic layer 50 is partially located in the effective region and partially overlaps with the top electrode and the second protrusion structure is formed at the top electrode in FIG. 11. In this way, more acoustic waves in the transverse mode are reflected back into the effective region of the resonator, thereby further improving the performance of the resonator.

Accordingly, as shown in FIG. 11, the third metallic layer 50 has an inner end located within the effective region. Further, the inner end of the third metallic layer 50 is located farther from the center of the effective region than the inner end of the non-metallic layer in the radial direction in the top view of the resonator. The end portion of the top electrode is formed into a double-stepped structure as the inner end of the third metallic layer and the inner end of the non-metallic layer staggered in the radial direction.

FIG. 12 is a schematic partial sectional view of a bulk acoustic wave resonator according to an exemplary embodiment of the present disclosure. The structure shown in FIG. 12 is similar to that shown in FIG.3 except that the etching barrier layer includes two layers including a first metallic layer 51a and a second non-metallic layer 51b in the embodiment shown in FIG. 12. The first metallic layer and the second non-metallic layer are both located within the effective region of the resonator and are staggered from each other. Therefore, the end portion of the top electrode is formed into two steps. In this way, more acoustic waves in the transverse mode are confined within the effective region of the resonator, thereby improving the performance of the resonator. The first metallic layer can reduce the series resistance Rₛ of the bottom electrode so that the electrical energy loss of the bottom electrode is reduced, thereby improving the Q value of the resonator. In particular, the second non-metallic layer may be located outside the effective region of resonance. In this case, the first non-metallic layer is formed into only one stepped structure at the end portion of the top electrode, and the stepped structure has an increased width. Thus, the Rp value of the resonator is further improved. Meanwhile, the non-metallic layer 51a and the non-metallic layer 51b can effectively avoid the deterioration of the Kt value of the resonator and the generation of sub-resonance in the region d₁.

In the embodiments shown in FIGS. 8 to 12, the etching barrier layer includes the non-metallic layer 51. As shown in FIGS. 8 to 12, a radial distance between the inner end of the non-metallic layer 51 and an end surface of the top electrode is defined as d₁. The piezoelectric layer is effectively spaced apart from the bottom electrode through the insulated non-metallic layer 51 in the region di, thereby avoiding the generation of sub-resonance and the deterioration of the Kt value of the resonator in the region d₁.

In addition to arranging the etching barrier layer at or near the bottom electrode connection layer, an extending portion extending from the etching barrier layer may be arranged along the effective region, i.e., around the effective region. The extending portion is formed into a stepped portion at the end portion of the top electrode. FIGS. 6 and 7 illustrate such an exemplary embodiment.

FIG. 6 is a schematic top view of a bulk acoustic wave resonator according to a further another exemplary embodiment of the present disclosure, and FIG. 7 is a schematic sectional view of the bulk acoustic wave resonator along line B-B in FIG. 6 according to an exemplary embodiment of the present disclosure.

Referring to FIG. 6, a top view of another film bulk acoustic resonator is illustrated. The structure shown in FIG. 6 is similar to that shown in FIG. 4 except that in addition to being located on a bottom electrode connection, the metallic layers extend around the effective region and extend to a top electrode connection in the vertical direction. The extending portion has a width in a range of 1 µm to 50 µm. In this embodiment, since the protrusion structure has an increased length, i.e., protrusion structures are provided at different positions. Accordingly, the acoustic waves in the transverse mode at the edge of the resonator is further reflected back into the effective region of the resonator, and partially converted into the acoustic waves in the longitudinal mode perpendicular to the surface of the piezoelectric layer, thereby further improving the Q value of the resonator. Moreover, the second metallic layer covers a larger area of the bottom electrode, thereby further reducing the series resistance Rₛ of the bottom electrode.

The structure shown in FIG. 7 is similar to that shown in FIG. 5 except that the bottom electrode is provided with a first metallic layer 20a and a second metallic layer 20a at both sides thereof as shown in FIG. 7. Therefore, the protrusion structure above the top electrode surrounding the effective region of the resonator has an increased length and thus more acoustic waves in the transverse mode are confined within the effective region of the resonator. Meanwhile, since the second metallic layer covers the larger area of the bottom electrode, the electrical energy loss of the bottom electrode is effectively reduced.

Based on the embodiment shown in FIGS. 6 and 7, in the embodiments shown in FIGS. 3 and 5, the resonator further includes a metallic extending portion extending from a portion of the first metallic layer in the effective region (see, for example FIG. 5) and/or from portions of the first metallic layer and the second metallic layer in the effective region (see, for example FIG. 3) on the same layer along at least part of the effective region, and a portion of the top electrode overlapping with the metallic extending portion in the top view of the resonator is formed into a stepped extension structure.

As for the embodiment in which the first metallic layer is only provided as the etching barrier layer, as shown in FIGS. 6 and 7, the resonator further includes a metallic extending portion extending from a portion of the first metallic layer within the effective region on the same layer along at least part of the effective region, and a portion of the top electrode overlapping with the metallic extending portion in the top view of the resonator is formed into a stepped extension structure.

As for the embodiment in which the etching barrier layer includes the non-metallic layer, as shown in FIGS. 6 and 7, the resonator further includes a non-metallic extending portion extending from a portion of the non-metallic layer in contact with the bottom electrode within the effective region on the same layer along at least part of the effective region, and a portion of the top electrode overlapping with the non-metallic extending portion in the top view of the resonator is formed into a stepped extension structure.

In addition, as shown in FIGS. 2 and 3, there is also provided a method for manufacturing the bulk acoustic wave resonator. Specifically, the etching barrier layer includes the first metallic layer and the second metallic layer, and the method includes:
providing the first metallic layer and the second metallic layer stacked on each other at predetermined positions of an upper surface of the bottom electrode, the first metallic layer being electrically connected to the bottom electrode and the second metallic layer, and an inner end of the first metallic layer being located closer to the center of the effective region than an inner end of the second metallic layer in the radial direction;
providing the piezoelectric layer, the piezoelectric layer covering the bottom electrode, a part of the first metallic layer, and the second metallic layer, and the piezoelectric layer being formed with a piezoelectric layer stepped portion through the inner end of the first metallic layer or the inner ends of the first metallic layer and second metallic layer staggered in the radial direction;
etching the piezoelectric layer at a predetermined position to form a through hole; and
depositing the bottom electrode electrical connection layer within the through hole, the bottom electrode electrical connection layer being electrically connected to the second metallic layer.

In the embodiment in which the etching barrier layer only includes the first metallic layer, there is provided a method for manufacturing the bulk acoustic wave resonator. Specifically, the etching barrier layer includes the first metallic layer, and the method includes:
providing the first metallic layer at a predetermined portion of an upper surface of the bottom electrode, the first metallic layer being electrically connected to the bottom electrode;
providing the piezoelectric layer, the piezoelectric layer covering the bottom electrode and the first metallic layer, and the piezoelectric layer being formed with a piezoelectric layer stepped portion through the inner end of the first metallic layer;
etching the piezoelectric layer at a predetermined position to form a through hole; and
depositing the bottom electrode electrical connection layer within the through hole, the bottom electrode electrical connection layer being electrically connected to the first metallic layer.

Based on the embodiment shown in FIG. 8 in which the etching barrier layer only includes the non-metallic layer, there is provided a method for manufacturing the bulk acoustic wave resonator. Specifically, the etching barrier layer includes the non-metallic layer, and the method includes:
providing the non-metallic layer, the non-metallic layer covering a predetermined portion of an upper surface of the bottom electrode and extending radially outward from an inner side of the edge of the effective region;
providing the piezoelectric layer, the piezoelectric layer covering the bottom electrode and the non-metallic layer, and the piezoelectric layer being formed with a piezoelectric layer stepped portion through the inner end of the non-metallic layer in the effective region;
etching the piezoelectric layer and the non-metallic layer at a predetermined position to form a through hole; and
depositing the bottom electrode electrical connection layer within the through hole, the bottom electrode electrical connection layer being electrically connected to the bottom electrode.

Based on the embodiment shown in FIG. 9 in which the etching barrier layer includes the non-metallic layer and the metallic layer, there is provided a method for manufacturing the bulk acoustic wave resonator. Specifically, the etching barrier layer includes the non-metallic layer and the metallic layer, and the method includes:
providing the metallic layer at a predetermined portion of the bottom electrode, the metallic layer being electrically connected to the bottom electrode;
providing the non-metallic layer, the non-metallic layer covering the metallic layer and a portion of an upper surface of the bottom electrode and extending radially outward from an inner side of the edge of the effective region, and an inner end of the metallic layer being located closer to the center of the effective region than the inner end of the metallic layer in the radial direction;
providing the piezoelectric layer, the piezoelectric layer covering the bottom electrode and the non-metallic layer, and the piezoelectric layer being formed with a piezoelectric layer stepped portion through an inner end of the non-metallic layer located in the effective region or through inner ends of the non-metallic layer and metallic layer staggered with each other in the radial direction;
etching the piezoelectric layer and the non-metallic layer at a predetermined position to form a through hole; and
depositing the bottom electrode electrical connection layer within the through hole, the bottom electrode electrical connection layer being electrically connected to the metallic layer.

Materials of components of the bulk acoustic wave resonator in embodiments of the present disclosure are exemplified briefly below.

The electrode may be made of gold (Au), tungsten (W), molybdenum (Mo), platinum (Pt), ruthenium (Ru), iridium (Ir), titanium tungsten (TiW), aluminum (Al), titanium (Ti) and other similar metals.

The piezoelectric layer may be made of aluminum nitride (AlN), doped aluminum nitride, zinc oxide (ZnO), lead zirconate titanate (PZT), lithium niobate (LiNbO₃), quartz, potassium niobate (KNbO₃) or lithium tantalate (LiTaO₃), or other materials.

The non-metallic material may be silicon dioxide, silicon nitride, silicon carbide, and other similar materials with relatively more etching selection than the material of the piezoelectric layer.

In view of the above description, the present disclosure provides the following technical solutions.
1. A bulk acoustic wave resonator includes:
   a sub strate;
   an acoustic mirror;
   a bottom electrode;
   a top electrode; and
   a piezoelectric layer,
   wherein the acoustic mirror, the bottom electrode, the piezoelectric layer and the top electrode overlap with each other in a thickness direction of the substrate to form an overlapping region, which is an effective region of the resonator;
   wherein the resonator further includes an etching barrier layer for the bottom electrode, the etching barrier layer is arranged on an upper surface of the bottom electrode; and
   wherein the etching barrier layer has an inner end located in the effective region and overlapping with the top electrode in a top view of the resonator, and the top electrode has an end portion formed into a stepped structure through the overlapping.
2. A filter includes the resonator as described above.
3. An electronic device includes the resonator as described above or the filter as described above. It should be noted that the electronic device herein includes, but not limited to, intermediate products such as radio frequency front-ends, filter and amplifier modules, and terminal products such as mobile phones, WIFI, and drones.
4. A method for manufacturing a bulk acoustic wave resonator is provided. The bulk acoustic wave resonator includes a substrate, an acoustic mirror, a bottom electrode, a top electrode, and a piezoelectric layer, and the acoustic mirror, the bottom electrode, the piezoelectric layer and the top electrode overlap with each other in a thickness direction of the substrate to form an overlapping region, which is an effective region of the resonator. The method includes:
   providing an etching barrier layer for the bottom electrode on an upper surface of the bottom electrode, the etching barrier layer having an inner end located within the effective region;
   forming a piezoelectric layer stepped portion on the piezoelectric layer covering the etching barrier layer through the inner end of the etching barrier layer; and
   providing the top electrode on the piezoelectric layer, and an end portion of the top electrode being formed into a stepped structure through the piezoelectric layer stepped portion.

In embodiments of the present disclosure, since the etching barrier layer is provided, the bottom electrode will not be damaged or the damage to the bottom electrode will be reduced during the etching of the piezoelectric layer on the bottom electrode. Further, since the total thickness of the metallic layers of the bottom electrode is increased, the series resistance Rₛ of the bottom electrode is effectively reduced so that the electrical energy loss of the bottom electrode is reduced, thereby improving the Q value of the resonator. Meanwhile, the upper surface of the top electrode is formed with the stepped structure through the inner end of the etching barrier layer. This stepped structure can reflect the acoustic waves in the transverse mode at the edge of the resonator back into the effective region, and partially convert the acoustic waves in the transverse mode into the acoustic waves in the longitudinal mode perpendicular to the surface of the piezoelectric layer, thereby further improving the Q value of the resonator.

Although the embodiments of the present disclosure have been shown and described, it should be understood for those skilled in the art that modifications may be made to these embodiments without departing from the principle and spirit of the present disclosure, and the scope thereof is defined by the appended claims and their equivalents.

## Claims

1. A bulk acoustic wave resonator, comprising:
a substrate;
an acoustic mirror;
a bottom electrode;
a top electrode; and
a piezoelectric layer,
wherein the acoustic mirror, the bottom electrode, the piezoelectric layer and the top electrode overlap with each other in a thickness direction of the substrate to form an overlapping region, and the overlapping region is an effective region of the resonator;
wherein the resonator further comprises an etching barrier layer for the bottom electrode, and the etching barrier layer is arranged on an upper surface of the bottom electrode; and
wherein the etching barrier layer has an inner end, the inner end is located within the effective region and overlaps with the top electrode in a top view of the resonator, and an end portion of the tope electrode is formed into a stepped structure through the overlapping.

2. The resonator according to claim 1, **characterized in that** the etching barrier layer comprises a first metallic layer and a second metallic layer, the first metallic layer and the second metallic layer are arranged on the bottom electrode in such a manner that the second metallic layer is stacked on the first metallic layer, and the first metallic layer has an inner end located closer to a center of the effective region than an inner end of the second metallic layer in a radial direction; and
the resonator further comprises a bottom electrode electrical connection layer directly electrically connected to the second metallic layer outside the effective region.

3. The resonator according to claim 2, **characterized in that** the inner end of the first metallic layer and the inner end of the second metallic layer both overlap with the end portion of the top electrode in the top view of the resonator; and
the stepped structure is a double-stepped structure.

4. The resonator according to claim 3, **characterized in that** the resonator further comprises:
a metallic extending portion extending from the first metallic layer and/or the second metallic layer on a same layer along at least part of the effective region,
wherein a portion of the top electrode overlapping with the metallic extending portion in the top view of the resonator is formed with a stepped extension structure.

5. The resonator according to claim 2, **characterized in that** the inner end of the first metallic layer overlaps with the end portion of the top electrode in the top view of the resonator, and the inner end of the second metallic layer is arranged outside the effective region; and
the end portion of the top electrode is formed into a single-step structure.

6. The resonator according to claim 5, **characterized in that** the resonator further comprises:
a metallic extending portion extending from a portion of the first metallic layer within the effective region and/or portions of the first metallic layer and the second metallic layer within the effective region on a same layer along at least part of the effective region,
wherein a portion of the top electrode overlapping with the metallic extending portion in the top view of the resonator is formed with a stepped extension structure.

7. The resonator according to any one of claims 2 to 6, **characterized in that** the first metallic layer has a thickness in a range of 10 Å to 5000 Å; and/or
the second metallic layer has a thickness in a range of 10 Å to 10000 Å.

8. The resonator according to any one of claims 2-6, **characterized in that** the first metallic layer is made of a material with a high acoustic impedance; and
the second metallic layer is made of a material with low electrical loss.

9. The resonator according to claim 1, **characterized in that** the etching barrier layer comprises a non-metallic layer provided on the upper surface of the bottom electrode, the non-metallic layer has an inner end located within the effective region and overlapping with the top electrode, wherein the end portion of the top electrode is formed into a stepped structure through the overlapping, and the resonator further comprises a bottom electrode electrical connection layer abutting against the non-metallic layer in a radial direction.

10. The resonator according to claim 9, **characterized in that** the bottom electrode electrical connection layer of the resonator is directly electrically connected to the bottom electrode.

11. The resonator according to claim 9, **characterized in that** the etching barrier layer further comprises a third metallic layer provided between the bottom electrode and the non-metallic layer, the third metallic layer is electrically connected to the bottom electrode, and the bottom electrode electrical connection layer is directly electrically connected to the third metallic layer outside the effective region.

12. The resonator according to claim 11, **characterized in that** the third metallic layer has an inner end located within the effective region, the inner end of the third metallic layer is located farther from a center of the effective region than the inner end of the non-metallic layer in the radial direction in the top view of the resonator, and the end portion of the top electrode is formed into a double-step structure through the inner end of the third metallic layer and the inner end of the non-metallic layer staggered from each other in the radial direction.

13. The resonator according to claim 11, **characterized in that** the third metallic layer has an inner end located within the effective region, the inner end of the third metallic layer is located closer to a center of the effective region than the inner end of the non-metallic layer in the radial direction in the top view of the resonator, and the end portion of the top electrode is formed into a double-step structure through the inner end of the third metallic layer and the inner end of the non-metallic layer staggered from each other in the radial direction.

14. The resonator according to claim 10, **characterized in that** the etching barrier layer further comprises a fourth metallic layer provided between the substrate and the bottom electrode, and the fourth metallic layer extends beyond the bottom electrode electrical connection layer in the radial direction in the top view of the resonator.

15. The resonator according to claim 9, **characterized in that** the resonator further comprises:
a non-metallic extending portion extending from a portion of the non-metallic layer in contact with the bottom electrode within the effective region on a same layer along at least part of the effective region,
wherein a portion of the top electrode overlapping with the non-metallic extending portion in the top view of the resonator is formed with a stepped extension structure.

16. A filter, comprising the bulk acoustic wave resonator according to any one of claims 1 to 15.

17. An electronic device, comprising the bulk acoustic wave resonator according to any one of claims 1 to 15 or the filter according to claim 16.

18. A method for manufacturing a bulk acoustic wave resonator, the bulk acoustic wave resonator comprising a substrate, an acoustic mirror, a bottom electrode, a top electrode, and a piezoelectric layer, the acoustic mirror, the bottom electrode, the piezoelectric layer and the top electrode overlapping with each other in a thickness direction of the substrate to form an overlapping region, and the overlapping region being an effective region of the resonator, **characterized in that** the method comprises:
providing an etching barrier layer for the bottom electrode on an upper surface of the bottom electrode, the etching barrier layer having an inner end located within the effective region;
forming a piezoelectric layer stepped portion on the piezoelectric layer covering the etching barrier layer through the inner end of the etching barrier layer; and
providing the top electrode on the piezoelectric layer, an end portion of the top electrode being formed into a stepped structure through the piezoelectric layer stepped portion.

19. The method according to claim 18, **characterized in that** the etching barrier layer comprises a non-metallic layer, and the method comprises:
providing the non-metallic layer, the non-metallic layer covering a predetermined portion of the upper surface of the bottom electrode and extending radially outward from an inner side of an edge of the effective region;
providing the piezoelectric layer, the piezoelectric layer covering the bottom electrode and the non-metallic layer, and the piezoelectric layer being formed with a piezoelectric layer stepped portion through an inner end of the non-metallic layer within the effective region;
etching the piezoelectric layer and the non-metallic layer at a predetermined position to form a through hole; and
depositing a bottom electrode electrical connection layer within the through hole, the bottom electrode electrical connection layer being electrically connected to the bottom electrode.

20. The method according to claim 18, **characterized in that** the etching barrier layer comprises a non-metallic layer and a metallic layer, and the method comprises:
providing the metallic layer at a predetermined position of the bottom electrode, the metallic layer being electrically connected to the bottom electrode;
providing the non-metallic layer on the metallic layer, the non-metallic layer extending radially outward from an inner side of an edge of the effective region and having an inner end, and the inner end of the non-metallic layer being located closer to or farther from a center of the effective region than an inner end of the metallic layer in the radial direction;
providing the piezoelectric layer, the piezoelectric layer covering the bottom electrode and the non-metallic layer or the metallic layer, and the piezoelectric layer being formed with a piezoelectric layer stepped portion through the inner end of the non-metallic layer within the effective region or through inner ends of the metallic layer and non-metallic layer staggered from each other in the radial direction;
etching the piezoelectric layer and the non-metallic layer at a predetermined position to form a through hole; and
depositing a bottom electrode electrical connection layer within the through hole, the bottom electrode electrical connection layer being electrically connected to the metallic layer.

21. The method according to claim 18, **characterized in that** the etching barrier layer comprises a first metallic layer and a second metallic layer, and the method comprises:
providing the first metallic layer and the second metallic layer stacked on each other at predetermined positions of the upper surface of the bottom electrode, the first metallic layer being electrically connected to the bottom electrode and the second metallic layer, and the first metallic layer having an inner end located closer to a center of the effective region than an inner end of the second metallic layer in a radial direction;
providing the piezoelectric layer, the piezoelectric layer covering the bottom electrode, a portion of the first metallic layer, and the second metallic layer, and the piezoelectric layer being formed with a piezoelectric layer stepped portion through the inner end of the first metallic layer or the inner ends of the first metallic layer and second metallic layer staggered from each other in the radial direction;
etching the piezoelectric layer at a predetermined position to form a through hole; and
depositing a bottom electrode electrical connection layer within the through hole, the bottom electrode electrical connection layer being electrically connected to the second metallic layer.
